# EUROPEAN PATENT APPLICATION

(11) **EP 4 501 884 A1**
(43) Date of publication of application: **05.02.2025**
(21) Application number: 23779555.4
(22) Date of filing: 14.03.2023
(51) Int. Cl.: C04B 35/453, C04B 35/053, C23C 14/08, C23C 14/24, C23C 14/34

(54) **OXIDE SINTERED BODY**

(30) Priority: 30.03.2022 JP 2022055149
(71) Applicant: Idemitsu Kosan Co., Ltd., Tokyo 100-8321 (JP)
(72) Inventor: TOMAI, Shigekazu, Tokyo 100-8321 (JP); KATSUMATA, Satoshi, Tokyo 100-8321 (JP); OYAMA, Masashi, Tokyo 100-8321 (JP)
(74) Representative: Gille Hrabal Partnerschaftsgesellschaft mbB Patentanwälte
(86) International application number: PCT/JP2023/009842
(87) International publication number: WO 2023/189535

(57) **Abstract**

An oxide sintered body comprising a cubic MgO into which Zn is solid-solved, a hexagonal ZnO into which Mg is solid-solved, and a ZnGa₂O₄ into which Mg is solid-solved.

## Description

### Technical Field

The present invention relates to an oxide sintered body and a material for film formation used for forming a thin film.

### Background Art

MgO-ZnO-based oxide is applied to a translucent ceramic for a color liquid crystal projector (Patent Document 1), an oxide semiconductor (Patent Document 2), a transparent electrode (Patent Document 3), and the like.

Although the sintered body is a material that emphasizes conductivity, it is mainly composed of ZnO, and therefore there is a problem in the translucency in the ultraviolet region.

In order to solve the above problems, the present inventors have disclosed an oxide sintered body which contains zinc, magnesium, a metallic element X having a positive trivalent or a positive tetravalent, and oxygen as constituent elements, and which is capable of obtaining a film having high translucency in an ultraviolet region and high conductivity by adjusting the ratio of these elements (Patent Document 4).

### Related Art Documents

### Patent Documents

[Patent Document 1] JP 2009-184898
[Patent Document 2] JP 2012-066968
[Patent Document 3] JP 2011-063866
[Patent Document 4] WO 2020/262433

### Summary of the Invention

After further studies, the present inventors have found that, when the film was formed using an oxide sintered body containing a cubic MgO into which Zn is solid-solved, a hexagonal ZnO into which Mg is solid-solved, and a ZnGa₂O₄ into which Mg is solid-solved, a film having high translucency in the ultraviolet region and high conductivity can be obtained.

One of objects of the invention is to provide an oxide sintered body capable of obtaining a film having high translucency in the ultraviolet region and high conductivity.

According to the present invention, the following oxide sintered body and the like are provided.
1. An oxide sintered body comprising a cubic MgO into which Zn is solid-solved, a hexagonal ZnO into which Mg is solid-solved, and a ZnGa₂O₄ into which Mg is solid-solved.
2. The oxide sintered body according to 1, wherein an atomic ratio of the gallium to the sum of the zinc, the magnesium, and the gallium [Ga/(Zn+Mg+Ga)] is 0.0001 or more and 0.090 or less.
3. The oxide sintered body according to 2, wherein the atomic ratio [Ga/(Zn+Mg+Ga)] is 0.007 or more and 0.070 or less.
4. The oxide sintered body according to 2, wherein the atomic ratio [Ga/(Zn+Mg+Ga)] is 0.008 or more and 0.060 or less.
5. The oxide sintered body according to 2, wherein the atomic ratio [Ga/(Zn+Mg+Ga)] is 0.010 or more and 0.050 or less.
6. The oxide sintered body according to any one of 2 to 5, wherein an atomic ratio of the magnesium to the sum of the zinc and the magnesium [Mg/(Zn+Mg)] is 0.25 or more and 0.80 or less.
7. The oxide sintered body according to 6, wherein the atomic ratio [Mg/(Zn+Mg)] is 0.30 or more and 0.70 or less.
8. A material for film formation, comprising the oxide sintered body according to any one of 1 to 7.
9. The material for film formation according to 8, which is a film-forming tablet.
10. The material for film formation according to 8, which is a sputtering target.
11. A thin film obtained by using the material for film formation according to any one of 8 to 10.

According to the present invention, it is possible to provide an oxide sintered body capable of obtaining a film having high translucency in the ultraviolet region and high conductivity.

### Brief Description of the Drawings

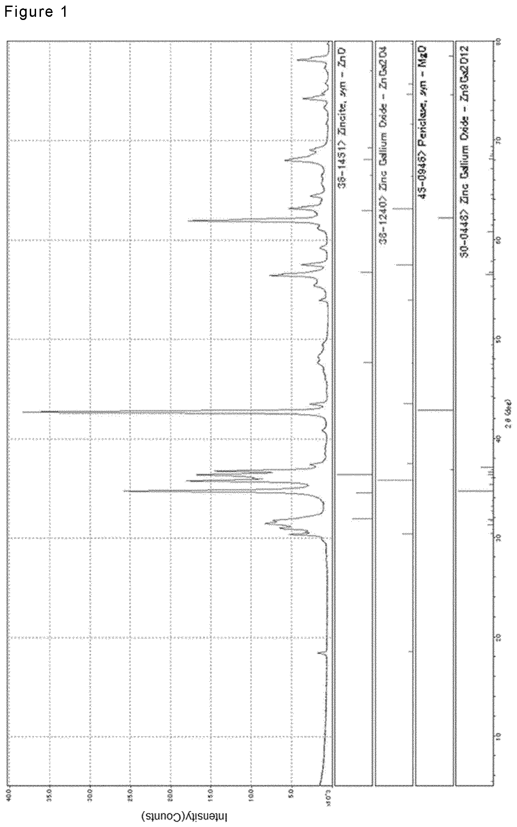

Figure 1 shows an analysis result of an XRD chart of an oxide sintered body of Example 1.

### Mode for Carrying out the Invention

An oxide sintered body according to one embodiment of the present invention includes a cubic MgO into which Zn is solid-solved, a hexagonal ZnO into which Mg is solid-solved, and a ZnGa₂O₄ into which Mg is solid-solved. As a result, the oxide sintered body capable of forming a film that achieves both the translucency in the ultraviolet region and the conductivity is obtained.

In the oxide sintered body of the present embodiment, the atomic ratio of the gallium to the sum of the zinc, the magnesium, and the gallium [Ga/(Zn+Mg+Ga)] is preferably 0.0001 or more and 0.090 or less. As a result, the oxide sintered body capable of forming a film that both further improved translucency in the ultraviolet region and high conductivity is obtained. The atomic ratio [Ga/(Zn+Mg+Ga)] is more preferably 0.007 or more and 0.070 or less, still more preferably 0.008 or more and 0.060 or less, and particularly preferably 0.010 or more and 0.050 or less.

In the oxide sintered body of the present embodiment, the atomic ratio of the magnesium to the sum of the zinc and the magnesium [Mg/(Zn+Mg)] is preferably 0.25 or more and 0.80 or less. As a result, the oxide sintered body capable of forming a film that both further improved translucency in the ultraviolet region and high conductivity is obtained. The atomic ratio [Mg/(Zn+Mg)] is more preferably 0.30 or more and 0.70 or less. Note that, when the atomic ratio is more than 0.80, a highly conductive film cannot be obtained even if the film obtained from the oxide sintered body is annealed. On the other hand, when the atomic ratio is less than 0.25, the ultraviolet transmittance of the film becomes low.

In the present embodiment, in addition to gallium, other metallic element X having a positive trivalent or positive tetravalent may be added. Examples of the metallic element X include Al, In, Sc and Y. The metallic element is preferably Al.

The atomic ratio of the zinc, the magnesium and the gallium can be controlled by preparing the atomic ratio of the starting material. In the atomic ratio of the oxide sintered body, the ratio of the zinc tends to be higher than the atomic ratio of the starting material, and the atomic ratio of the gallium tends to be approximately the same.

The atomic ratio of each element contained in the oxide sintered body can be determined by analyzing the contained elements by an inductively coupled plasma-atomic emission spectrometer (ICP-AES). Specifically, when a sample of solutions is atomized with a nebulizer and introduced into an argon plasma (about 5000 to 8000°C), the elements in the sample absorb thermal energy and are excited, and the orbital electrons move from the ground state to the orbit with a higher energy level and then to the orbit with a lower energy level. At this time, the difference in energy is emitted as light and emitted. Since this light shows an element-specific wavelength (spectral line), the presence of an element can be confirmed by the presence or absence of a spectral line (qualitative analysis). Further, since the magnitude of the spectral line (emission intensity) is proportional to the number of elements in the sample, the sample concentration can be determined by comparing with a standard solution having a known concentration (quantitative analysis). After identifying the elements contained in the sample by the qualitative analysis, and then the content is determined by quantitative analysis, and the atomic ratio of each element is determined from the result.

The constituent elements of the oxide sintered body of the present embodiment may include essentially of Mg, Zn, Ga and O (consisting essentially of). For example, 70 mol% or more, 80 mol% or more, or 90 mol% or more of the constituent elements of the oxide sintered body of the present embodiment may be Mg, Zn, Ga and O. Further, the constituent elements of the oxide sintered body of the present embodiment may consist of Mg, Zn, Ga and O. In this case, the oxide sintered body may contain inevitable impurities.

The inclusion of the above-described oxides in the oxide sintered body can be confirmed by checking XRD charts obtained by the X-ray diffraction (XRD) method and the database (PDF: Powder Diffraction File) of ICDD (International Centre for Diffraction Data).

The fact that the other metallic elements are solid-solved into each crystal can be determined by comparing the lattice constant (measured value) obtained by XRD with the lattice constant (PDF value) described in PDF. For example, in the case of the crystal which Zn is solid-solved into, the measured value is larger than PDF value.

If the solid solution status cannot be determined by XRD, it can be determined by mapping position for each element using respective characteristic X-rays, for example, by an Energy-Dispersive X-ray Spectrometer (EDS) attached to a Scanning Electrons Microscope (SEM).

The oxide sintered body of the present embodiment can be produced by, for example, a step of mixing a raw material powder to prepare a mixture powder, a step of molding the mixed powder to form a molded body, and a step of sintering the molded body.

As the starting materials, the compound powder containing the Mg, the compound powder containing the Zn, and the compound powder containing the Ga can be used. The compound is preferably an oxide. Examples include MgO, ZnO and Ga₂O₃.

The mixing proportion of the raw material powder can be prepared, for example, by considering the atomic ratio of the oxide sintered body to be obtained.

The average particle size of the raw material powder is preferably 0.1 to 1.2 µm, more preferably 0.5 to 1.0 µm. The average particle size of the raw material powder can be measured by a laser diffraction particle size analyzer or the like.

The mixing and molding method of the raw materials is not particularly limited, and a known method can be employed. In addition, a binder may be added at the time of mixing.

The mixing of the raw materials can be performed using a known device such as a ball mill, a bead mill, a jet mill, or an ultrasonic device. The mixing time may be appropriately adjusted, but is preferably about 6 to 100 hours.

As the molding method, for example, the mixed powder can be pressure-molded to form a molded body. This process allows to be molded into a shape of the product (for example, a shape suitable as a sputtering target).

The molded article can be obtained by filling the mixed powder into a mold and pressurizing the molded article, for example, at a 1000 kg/cm² or higher, usually by a mold press or a cold isostatic pressing (ClP).

At the time of molding, a molding aid such as polyvinyl alcohol, polyethylene glycol, methyl cellulose, polywax, oleic acid, or stearic acid may be used.

The obtained molded body can be heated, for example, at a temperature of 1200 to 1650°C for 2 hours or more to obtain an oxide sintered body.

The heating temperature is preferably 1350 to 1600°C, more preferably 1400 to 1600°C, and even more preferably 1450 to 1500°C. The heating time is preferably 2 to 72 hours, more preferably 3 to 48 hours, even more preferably 4 to 24 hours.

The sintering is usually performed by heating the molded body in an air atmosphere or an oxygen gas atmosphere. The oxygen gas atmosphere is preferably an atmosphere having an oxygen concentration of, for example, 10 to 50% by volume.

The oxide sintered body of the present embodiment can be suitably used as a material for film formation used for forming a thin film having a composition same as the oxide sintered body, for example, tablets used for film formation by vacuum deposition method or ion plating method, and sputtering targets. The thin film obtained from the material for film formation of the present embodiment can be used as a transparent conductive film used for an electrode substrate such as an ultraviolet emitting diode or an ultraviolet emitting laser diode.

Note that, by heat-treating the film at a high temperature after the film formation, the ultraviolet transmittance and conductivity of the film are improved. In the film immediately after the film formation, the oxide of zinc, the oxide of magnesium, and the like are uniformly mixed. It is presumed that heat treatment of the film in this state causes aggregation, separating, and the like of the oxide, and consequently, the oxide of zinc forms a network, thereby exhibiting conductivity, while the oxide of magnesium aggregates in the gap among the networks of the oxide of zinc, whereby ultraviolet ray is transmitted.

The heat treatment temperature of the electrode layer is preferably 750°C or more, more preferably 900°C or more.

The tablet can be produced, for example, by cutting or polishing an oxide sintered body obtained by molding a raw material into a desired shape and sintering. The sputtering target can be produced, for example, by cutting or polishing an oxide sintered body and bonding it to a backing plate.

The uneven surface can be removed by cutting. In addition, the size of the oxide sintered body can be specified. The surface may be polished at #200, or #400, or even #800. As a result, it is possible to suppress abnormal discharge and generation of particles during sputtering.

After the polished oxide sintered body is cleaned as needed, a bonding material such as indium-metal solder is applied to the bonding surface, and is bonded to the backing plate, whereby a sputtering target can be obtained.

### Examples

### Example 1

### (A)Preparation of oxide sintered body

Zinc oxide (ZnO) powder having an average particle size of 1 µm or less, magnesium oxide (MgO) powder having an average particle size of 1 µm or less, and gallium oxide (Ga₂O₃) powder having an average particle size of 1 µm or less were weighed and mixed so that atomic ratios of the respective metals were as shown in Table 1. Regarding the mass fraction of the mixed powder, ZnO was 60.9% by mass, MgO was 31.6% by mass, Ga₂O₃ was 7.5% by mass.

The mixed powder was placed in a resin-made pot, then water was added thereto, and the mixed powder was mixed in a wet ball mill for 20 hours using a hard ZrO₂ ball as a grinding media. The resulting mixed slurry was removed, filtered, dried and granulated. The obtained granulated product was placed in a mold, and molded by pressing to 3 ton/cm² by cold isostatic pressing.

The obtained molded body was placed in a sintering furnace, and the molded body was sintered while oxygen was flowed in at a rate of 5 L/min per 0.1 m³ of the internal volume of the furnace.

The temperature in the sintering furnace was raised at 1°C/min from room temperature to 1000°C, and at 3°C/min from 1000°C to 1470°C, and the sintering was performed for 5 hours at 1470°C. Thereafter, the inflow of oxygen was stopped, and the temperature in the furnace was lowered from 1470°C to 1300°C at 10°C/min. Then, while flowing Ar at a proportion of 10 L/min per 0.1 m³ of the internal volume of the furnace, the furnace temperature was maintained at 1300°C for 3 hours. Thereafter, the oxide sintered body was obtained by cooling.

The composition and relative density of the obtained oxide sintered body were evaluated. The results are shown in Table 2.

**Table 1**

| | Atomic ratios of starting raw materials | | | | |
|---|---|---|---|---|---|
| | Mg | Zn | Ga | Mg/(Zn+Mg) | Ga/(Zn+Mg+Ga) |
| Example 1 | 0.48 | 0.47 | 0.05 | 0.505 | 0.05 |
| Example 2 | 0.50 | 0.49 | 0.01 | 0.505 | 0.01 |
| Example 3 | 0.63 | 0.32 | 0.05 | 0.663 | 0.05 |
| Comparative Example 1 | 0.505 | 0.495 | 0 | 0.505 | 0 |
| Comparative Example 2 | 0.537 | 0.368 | 0.095 | 0.593 | 0.095 |

**Table 2**

| | Atomic ratios of oxide sintered body | | | | | Relative density (%) |
|---|---|---|---|---|---|---|
| | Mg | Zn | Ga | Mg/(Zn+Mg) | Ga/(Zn+Mg+Ga) | |
| Example 1 | 0.475 | 0.475 | 0.050 | 0.500 | 0.050 | 81.59 |
| Example 2 | 0.495 | 0.495 | 0.010 | 0.500 | 0.010 | 90.00 |
| Example 3 | 0.620 | 0.330 | 0.050 | 0.653 | 0.050 | 89.04 |
| Comparative Example 1 | 0.500 | 0.500 | 0 | 0.500 | 0 | 91.71 |
| Comparative Example 2 | 0.534 | 0.371 | 0.095 | 0.590 | 0.095 | 80.00 |

Evaluation procedure is as follows.

### (1) Atomic Ratio of Metallic Elements in Oxide Sintered Body

A part of the obtained oxide sintered body was cut out, dissolved in an acid, and analyzed by an inductively coupled plasma atomic emission spectrometer.

### (2) Relative Density

The relative density was calculated by measuring the actual density of the oxide sintered body by Archimedes method using water and dividing by the theoretical density calculated based on the composition. The theoretical density was determined by averaging the density of MgO without oxygen defect as 3.59 g/cm³, ZnO as 5.61 g/cm³, and Ga₂O₃ as 5.88 g/cm³, for the composition proportion (mass fraction) of the sintered body.

### (3) XRD measurement

The measurements were made with the following apparatus and conditions.
· Apparatus: Ultima-III, manufactured by Rigaku
· X-ray: Cu-Kα ray (wavelength: 1.5406 Å, monochromatized by graphite monochromator)
· 2θ-θ reflection method, continuous scan (1.0°/min)
· Sampling interval: 0.02°
· Slitting DS, SS:2/3°, RS:0.6 mm

The XRD measurement was analyzed by an integrated powder X-ray analysis software (PDXL2, manufactured by Rigaku) to obtain the crystalline structure and the lattice constant of the sintered oxide body. The crystalline structure was confirmed by ICDD card (PDF) below.
ZnO:36-1451 (hexagonal)
MgO:45-0946 (cubic)
ZnGa₂O₄:38-1240

Figure 1 shows the result of analysis of XRD charts. From Figure 1, it was confirmed that ZnO, MgO and ZnGa₂O₄ were included in the oxide sintered body. The results are shown in Table 3. In the table, the case where each crystal structure is contained is denoted by "∘", and the case where each crystal structure is not contained is denoted by "×".

**Table 3**

| | MgO into which Zn was solid-solved (cubic) | ZnO into which Mg was solid-solved (hexagonal) | ZnGa₂O₄ into which Mg was solid-solved |
|---|---|---|---|
| Example 1 | ○ | ○ | ○ |
| Example 2 | ○ | ○ | ○ |
| Example 3 | ○ | ○ | ○ |
| Comparative Example 1 | ○ | ○ | × |
| Comparative Example 2 | ○ | ○ | × |

### (B)Preparation of Sputtering Targets

The obtained oxide sintered body was polished with a cup grinding wheel on a surface that would be the sputtered surface and processed to 100 mm in diameter and 5 mm in thickness. Using an In-based alloy, a backing plate was bonded to the polished oxide sintered body to prepare a sputtering target.

A thin film was actually formed using a sputtering target prepared from an oxide sintered body and evaluated. Film formation conditions were as follows.

A sapphire substrate (Thickness 0.5 mm) was placed in an ultrasonic cleaner and washed with trichloroethylene for 5 minutes, with acetone for 5 minutes, with methanol for 5 minutes, and finally with distilled water for 5 minutes.

The substrate was set in a sputtering device (ULVAC: ACS-4000), and a film was formed on substrate at 25°C using Ar as a sputtering gas to form a film having a thickness 100 nm.

### (2) Heat Treatment

The substrate having the film formed in the above (1) was subjected to heat treatment (activation annealing) at 950°C for 5 minutes in a nitrogen atmosphere. For the film after the heat treatment, the surface-resistance was measured using a LORESTA FP manufactured by Mitsubishi Chemical. A spectrophotometer (manufactured by Shimadzu Corporation: UV-2600) was used to evaluate ultraviolet transmittance.

Evaluation results are shown in Table 4.

**Table 4**

| | Ultraviolet Transmittance (%) | Resistance (Ωcm) |
|---|---|---|
| Example 1 | 18 | 0.02 |
| Example 2 | 18 | 0.05 |
| Example 3 | 18 | 0.05 |
| Comparative Example 1 | 15 | 1000 |
| Comparative Example 2 | 12 | 0.001 |

### Examples 2 and 3 and Comparative Examples 1 and 2

The oxide sintered body and the sputtering target were produced and evaluated in the same manner as in Example 1, except that the raw material was weighed to the atomic ratio of the respective metallic elements shown in Table 1, and was mixed. The results are shown in Tables 2 to 4.

In Examples 1 to 3, the ultraviolet transmittance and the resistance value were also preferably obtained. On the other hand, in Comparative Example 1, the resistance value was larger and the ultraviolet transmittance was lower than in Examples 1 to 3. In Comparative Example 2, the resistance value was smaller than that in Examples 1 to 3, but the ultraviolet transmittance was lower.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification and the specification of Japanese application(s) on the basis of which the present application claims Paris convention priority are incorporated herein by reference in its entirety.

## Claims

1. An oxide sintered body comprising a cubic MgO into which Zn is solid-solved, a hexagonal ZnO into which Mg is solid-solved, and a ZnGa₂O₄ into which Mg is solid-solved.

2. The oxide sintered body according to claim 1, wherein an atomic ratio of the gallium to the sum of the zinc, the magnesium, and the gallium [Ga/(Zn+Mg+Ga)] is 0.0001 or more and 0.090 or less.

3. The oxide sintered body according to claim 2, wherein the atomic ratio [Ga/(Zn+Mg+Ga)] is 0.007 or more and 0.070 or less.

4. The oxide sintered body according to claim 2, wherein the atomic ratio [Ga/(Zn+Mg+Ga)] is 0.008 or more and 0.060 or less.

5. The oxide sintered body according to claim 2, wherein the atomic ratio [Ga/ (Zn+Mg+Ga)] is 0.010 or more and 0.050 or less.

6. The oxide sintered body according to any one of claims 2 to 5, wherein an atomic ratio of the magnesium to the sum of the zinc and the magnesium [Mg/(Zn+Mg)] is 0.25 or more and 0.80 or less.

7. The oxide sintered body according to claim 6, wherein the atomic ratio [Mg/ (Zn+Mg)] is 0.30 or more and 0.70 or less.

8. A material for film formation, comprising the oxide sintered body according to any one of claims 1 to 7.

9. The material for film formation according to claim 8, which is a film-forming tablet.

10. The material for film formation according to claim 8, which is a sputtering target.

11. A thin film obtained by using the material for film formation according to any one of claims 8 to 10.
